(19) **Europäisches Patentamt / European Patent Office / Office européen des brevets**

(11) **EP 4 518 152 A1**

(12) **EUROPEAN PATENT APPLICATION**
published in accordance with Art. 153(4) EPC

(43) Date of publication:
**05.03.2025 Bulletin 2025/10**

(21) Application number: **23810521.7**

(22) Date of filing: **05.01.2023**

(51) International Patent Classification (IPC):
**H03F 1/32** (2006.01)

(52) Cooperative Patent Classification (CPC):
**H03F 1/32**

(86) International application number:
**PCT/CN2023/070659**

(87) International publication number:
**WO 2023/226444 (30.11.2023 Gazette 2023/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.05.2022 RU 2022114387**

(71) Applicant: **Huawei Technologies Co., Ltd.
Shenzhen, Guangdong 518129 (CN)**

(72) Inventors:
• **VOROBYEV, Andrey
Shenzhen, Guangdong 518129 (CN)**
• **MAXIM, Nefedov
Shenzhen, Guangdong 518129 (CN)**
• **ZHAO, Yifan
Shenzhen, Guangdong 518129 (CN)**
• **WU, Yanming
Shenzhen, Guangdong 518129 (CN)**
• **GAO, Liuchuang
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **DIGITAL PRE-DISTORTION CIRCUIT, AND DIGITAL PRE-DISTORTION METHOD AND DEVICE**

(57) Embodiments of this application provide a digital pre-distortion circuit and method and an apparatus. The digital pre-distortion circuit includes a digital pre-distortion module and a power amplifier. The digital pre-distortion module is configured to: obtain a first feature of a first input signal and a second feature of the first input signal, determine a first coefficient based on the first feature of the first input signal, determine a second coefficient based on the second feature, generate a second signal based on the first input signal and the first coefficient, generate a first output signal based on the second signal and the second coefficient, and input the first output signal to the power amplifier. The power amplifier is configured to amplify the first output signal, to generate a second output signal. The digital pre-distortion circuit provided in embodiments of this application can avoid signal distortion generated after an input signal passes through a power amplifier.

First input signal x(n) → Digital pre-distortion processing unit 210 → First output signal z(n) → Power amplifier 220 → Second output signal z(n)

FIG. 2

## Description

This application claims priority to Russian Patent Application No. 2022114387, filed with the Federal Service for Intellectual Property of the Russian Federation on May 27, 2022, and entitled "DIGITAL PRE-DISTORTION CIRCUIT, DIGITAL PRE-DISTORTION METHOD, AND APPARATUS", which is incorporated herein by reference in its entirety.

## TECHNICAL FIELD

Embodiments of this application relate to the field of electronic devices, and more specifically, to a digital pre-distortion circuit, a digital pre-distortion method, and an apparatus.

## BACKGROUND

In a communication system, digital pre-distortion (digital pre-distortion, DPD) is introduced to avoid non-linearity and memory distortion of a signal caused because a power amplifier (power amplifier, PA) operates in a non-linear area. As power amplifiers develop toward high efficiency, a large bandwidth, low power consumption, and high integration, a current digital pre-distortion system can no longer meet a requirement of the power amplifiers.

## SUMMARY

Embodiments of this application provide a digital pre-distortion circuit, a digital pre-distortion method, and an apparatus, so that a DPD coefficient and an index coefficient can be determined based on a first feature and a second feature of an input signal, to perform digital pre-distortion and avoid a non-linear output signal obtained through a power amplifier.

According to a first aspect, a digital pre-distortion circuit is provided. The digital pre-distortion circuit includes a digital pre-distortion module and a power amplifier. The digital pre-distortion module is configured to obtain a first feature of a first input signal and a second feature of the first input signal, where the first feature of the first input signal includes at least one of the following: an amplitude of the first input signal, an in-phase component of the first input signal, and a quadrature component of the first input signal, and the second feature includes at least one of the following: a bandwidth of the first input signal, a temperature at which the digital pre-distortion circuit processes the first input signal, a frequency of the first input signal, a modulation format of the first input signal, and a standing wave generated when the digital pre-distortion circuit processes the first input signal. The digital pre-distortion module is configured to: determine a first coefficient based on the first feature, and determine a second coefficient based on the second feature, and is configured to: generate a second signal based on the first input signal and the first coefficient, generate a first output signal based on the second signal and the second coefficient, and input the first output signal to the power amplifier.

The power amplifier is configured to amplify the first output signal, to generate a second output signal.

According to the digital pre-distortion circuit provided in this embodiment of this application, the DPD module may determine the first coefficient and the second coefficient based on the first feature and the second feature of the first input signal, perform digital pre-distortion on the first input signal by using the first coefficient and the second coefficient, and then input a first output signal obtained through digital pre-distortion to the power amplifier, to obtain the second output signal that is linear and undistorted.

With reference to the first aspect, in some implementations of the first aspect, the digital pre-distortion circuit further includes a coefficient module. The coefficient module stores a correspondence between the first feature and the first coefficient and a correspondence between the second feature and the second coefficient. The digital pre-distortion module is specifically configured to: extract the first coefficient from the coefficient module based on the first feature, and extract the second coefficient from the coefficient module based on the second feature. The first feature and the second feature

With reference to the first aspect, in some implementations of the first aspect, the digital pre-distortion module includes N digital pre-distortion submodules and a synthesis module. The N digital pre-distortion submodules are configured to: determine N first sub-coefficients based on the first feature, and determine N second sub-coefficients based on the second feature, where $N \geq 1$ and N is an integer, and the N first sub-coefficients are different; generate N second sub-signals based on the first input signal and the N first sub-coefficients; and generate N first output sub-signals based on the N second sub-signals and the N second sub-coefficients. The synthesis module is configured to generate the first output signal based on the N first output sub-signals.

With reference to the first aspect, in some implementations of the first aspect, the first feature further includes data carried in the first input signal and/or a signal amplitude of a second input signal and/or data carried in the second input signal. The second input signal may be an input signal that has a specific time interval from the first input signal.

With reference to the first aspect, in some implementations of the first aspect, the digital pre-distortion circuit further includes a digital-to-analog converter. The digital-to-analog converter is configured to: obtain the first output signal from the digital pre-distortion circuit, perform digital-to-analog conversion on the first output signal, and input a first output signal obtained through the digital-to-analog conversion to the power amplifier.

With reference to the first aspect, in some implementations of the first aspect, the digital pre-distortion circuit further includes a preprocessing module and a solution module. An algorithm used to solve for a coefficient is preset in the solution module, and the first input signal and the second output signal are input to the preprocessing module. When an adjacent channel leakage ratio of the first input signal to the second output signal exceeds a first threshold and/or an error vector magnitude exceeds a second threshold, the preprocessing module is configured to: preprocess the first input signal and the second output signal, to align the first input signal with the second output signal, and input a preprocessed first input signal and a preprocessed second output signal to the solution module; the solution module is configured to process the preprocessed first input signal and the preprocessed second output signal according to the algorithm, to generate a third coefficient and a fourth coefficient; the digital pre-distortion module is further configured to: generate a third signal based on the first input signal and the third coefficient, generate a third output signal based on the third signal and the fourth coefficient, and input the third output signal to the power amplifier; and the power amplifier is configured to amplify the third output signal.

In this embodiment of this application, when the ACLR of the first input signal to the second output signal exceeds the first threshold or the EVM exceeds the second threshold, the digital pre-distortion circuit may re-solve for a new coefficient based on the first input signal and the second output signal, so that the digital pre-distortion circuit can generate the third output signal based on the third coefficient and the fourth coefficient, and then input the third output signal to the power amplifier, to further obtain the undistorted fourth output signal.

According to a second aspect, a digital pre-distortion method is provided. The method includes: obtaining a first feature of a first input signal and a second feature of the first input signal, where the first feature of the first input signal includes at least one of the following: an amplitude of the first input signal, an in-phase component of the first input signal, and a quadrature component of the first input signal, and the second feature includes at least one of the following: a bandwidth of the first input signal, a temperature at which a digital pre-distortion circuit processes the first input signal, a frequency of the first input signal, a modulation format of the first input signal, and a standing wave generated when the digital pre-distortion circuit processes the first input signal; determining a first coefficient based on the first feature, and determining a second coefficient based on the second feature; generating a second signal based on the first input signal and the first coefficient; generating a first output signal based on the second signal and the second coefficient; and performing power amplification on the first output signal, to generate a second output signal.

With reference to the second aspect, in some implementations of the second aspect, the determining a first coefficient and a second coefficient based on the first feature and the second feature of the first input signal includes: determining N first sub-coefficients based on the first feature, and determining N second sub-coefficients based on the second feature, where the N first sub-coefficients are different; the generating a second signal based on the first input signal and the first coefficient includes: generating N second sub-signals based on the first input signal and the N first sub-coefficients; and the generating a first output signal based on the second signal and the second coefficient includes: generating N first output sub-signals based on the N second sub-signals and the N second sub-coefficients; and generating the first output signal based on the N first output sub-signals.

With reference to the second aspect, in some implementations of the second aspect, when an adjacent channel leakage ratio of the first input signal to the second output signal exceeds a first threshold and/or an error vector magnitude exceeds a second threshold, the method further includes: preprocessing the first input signal and the second output signal, to align the first input signal with the second output signal; processing a preprocessed first input signal and a preprocessed second output signal, to generate a third coefficient and a fourth coefficient; generating a third signal based on the first input signal and the third coefficient; generating a third output signal based on the third signal and the fourth coefficient; and performing power amplification on the third output signal, to generate a fourth output signal.

With reference to the second aspect, in some implementations of the second aspect, the first feature further includes data carried in the first input signal and/or a signal amplitude of a second input signal and/or data carried in the second input signal. The second input signal may be an input signal that has a specific time interval from the first input signal.

According to a third aspect, a transmitting apparatus is provided. The transmitting apparatus includes a transceiver unit, a digital pre-distortion unit, and a power amplification unit. The transceiver unit is configured to receive a first input signal. The digital pre-distortion unit is configured to: obtain a first feature of the first input signal and a second feature of the first input signal, where the first feature of the first input signal includes at least one of the following: an amplitude of the first input signal, an in-phase component of the first input signal, and a quadrature component of the first input signal, and the second feature includes at least one of the following: a bandwidth of the first input signal, a temperature at which the digital pre-distortion circuit processes the first input signal, a frequency of the first input signal, a modulation format of the first input signal, and a standing wave generated when the digital pre-distortion circuit processes the first input signal; determine a first coefficient based on the first feature, and determine a second coefficient based on the second feature; generate a second signal based on the first input signal and the first coefficient; generate a first output signal based on the second signal and the second coefficient; and input the first output signal to the power amplification unit. The power amplification unit is configured to amplify the first output signal, to generate a second output signal. The transceiver unit is further configured to send the second output signal.

With reference to the third aspect, in some implementations of the third aspect, the transmitting apparatus further includes a coefficient unit. The coefficient unit stores a correspondence between the first feature and the first coefficient and a correspondence between the second feature and the second coefficient. The digital pre-distortion unit is specifically configured to: extract the first coefficient from the coefficient unit based on the first feature, and extract the second coefficient from the coefficient unit based on the second feature.

With reference to the third aspect, in some implementations of the third aspect, the digital preprocessing unit is specifically configured to: determine N first sub-coefficients based on the first feature, and determine N second sub-coefficients based on the second feature, where the N first sub-coefficients are different; generate N second sub-signals based on the first input signal and the N first coefficients; generate N first output sub-signals based on the N second sub-signals and the N second sub-coefficients; and generate the first output signal based on the N first output sub-signals.

With reference to the third aspect, in some implementations of the third aspect, the transmitting apparatus further includes a preprocessing unit and a solution unit. An algorithm used to solve for a coefficient is preset in the solution unit, and the first input signal and the second output signal are input to the preprocessing unit. When an adjacent channel leakage ratio of the first input signal to the second output signal exceeds a first threshold or an error vector magnitude exceeds a second threshold, the preprocessing unit is configured to preprocess the first input signal and the second output signal, to align the first input signal with the second output signal; the preprocessing unit is further configured to input a preprocessed first input signal and a preprocessed second output signal to the solution unit; the solution unit is configured to process the preprocessed first input signal and the preprocessed second output signal according to the algorithm, to generate a third coefficient and a fourth coefficient; the digital pre-distortion unit is further configured to generate a third signal based on the first input signal and the third coefficient; generate a third output signal based on the third signal and the fourth coefficient; and input the third output signal to the power amplification unit; the power amplification unit is further configured to amplify the third output signal; and the transceiver unit is further configured to send an amplified third output signal.

With reference to the third aspect, in some implementations of the third aspect, the first feature further includes data carried in the first input signal and/or a signal amplitude of a second input signal and/or data carried in the second input signal. The second input signal may be an input signal that has a specific time interval from the first input signal.

According to a fourth aspect, a transmitting device is provided. The transmitting device includes the digital pre-distortion circuit according to the first aspect and any one of the possible implementations of the first aspect, or includes the transmitting apparatus according to the third aspect and any one of the possible implementations of the third aspect.

According to a fifth aspect, a transmitting device is provided, including one or more processors, one or more memories, and one or more transceivers. The one or more memories store one or more computer programs, the one or more computer programs include instructions, and when the instructions are executed by the one or more processors, the technical solution according to the second aspect and any one of the possible designs of the second aspect is performed.

According to a sixth aspect, a chip is provided. The chip is coupled to a memory in an electronic device, and is configured to: invoke a computer program stored in the memory, and perform the technical solution according to the second aspect and any one of the possible designs of the second aspect in embodiments of this application. In embodiments of this application, "coupling" means that two components are directly or indirectly combined with each other.

According to a seventh aspect, a computer-readable storage medium is provided. The computer-readable storage medium includes a computer program. When the computer program is run on a communication apparatus, an electronic device is enabled to perform the technical solution according to the second aspect and any one of the possible designs of the second aspect.

According to an eighth aspect, a computer program product is provided. The computer program product includes a computer program. When the computer program is run, a computer is enabled to perform the technical solution according to the second aspect and any one of the possible designs of the second aspect.

For beneficial effects of the second aspect to the eighth aspect, refer to the beneficial effects of the first aspect. Details are not described again.

## BRIEF DESCRIPTION OF DRAWINGS

FIG. 1 is a schematic flowchart of a linearization solution for digital pre-distortion;
FIG. 2 is a diagram of a structure of a digital pre-distortion circuit according to an embodiment of this application;

FIG. 3 is a diagram of determining a first coefficient by a digital pre-distortion module according to an embodiment of this application;

FIG. 4 is another diagram of determining a first coefficient by a digital pre-distortion module according to an embodiment of this application;

FIG. 5 is a diagram of a structure of a digital pre-distortion module according to an embodiment of this application;

FIG. 6 is a diagram of a structure of a digital pre-distortion submodule according to an embodiment of this application;

FIG. 7 is a diagram of a structure of a coefficient module according to an embodiment of this application;

FIG. 8 is a diagram of a structure of a digital pre-distortion circuit according to an embodiment of this application;

FIG. 9 is a diagram of a structure of a digital pre-distortion circuit according to an embodiment of this application;

FIG. 10 is a diagram of a structure of a digital pre-distortion circuit according to an embodiment of this application;

FIG. 11 is a schematic flowchart of a digital pre-distortion method according to an embodiment of this application;

FIG. 12 is a schematic flowchart of an example of a digital pre-distortion method according to an embodiment of this application;

FIG. 13 is a schematic flowchart of an example of a digital pre-distortion method according to an embodiment of this application;

FIG. 14 shows a transmitting apparatus according to an embodiment of this application; and

FIG. 15 shows a communication apparatus according to an embodiment of this application.

## DESCRIPTION OF EMBODIMENTS

The following describes technical solutions of this application with reference to accompanying drawings.

The technical solutions of embodiments of this application may be applied to various communication systems, such as a global system for mobile communications (Global System for Mobile communications, GSM), a code division multiple access (Code Division Multiple Access, CDMA) system, a wideband code division multiple access (Wideband Code Division Multiple Access, WCDMA) system, a general packet radio service (General Packet Radio Service, GPRS), a long term evolution (Long Term Evolution, LTE) system, an LTE frequency division duplex (Frequency Division Duplex, FDD) system, an LTE time division duplex (Time Division Duplex, TDD) system, a universal mobile telecommunications system (Universal Mobile Telecommunications System, UMTS), a worldwide interoperability for microwave access (Worldwide Interoperability for Microwave Access, WiMAX) communication system, a 5th generation (5th Generation, 5G) system or a new radio (New Radio, NR) system, and a future evolved communication system. Further, the technical solutions provided in embodiments of this application may be applied to another communication system that needs to implement digital pre-distortion. In the communication system, a device using the technical solutions provided in embodiments of this application is a transmitting device, and the transmitting device may be a network device, or may be a terminal device. The transmitting device may also be referred to as a sending device.

The terminal device is a device having a wireless transceiver function, and may be deployed on land, including an indoor device, an outdoor device, a handheld device, a wearable device, or a vehicle-mounted device, may be deployed on a water surface (for example, on a ship), or may be deployed in air (for example, on a plane, a balloon, or a satellite). The terminal device may communicate with a core network through a radio access network (radio access network, RAN), and exchange a voice and/or data with the RAN. The terminal device may be a mobile phone (mobile phone), a tablet computer (Pad), a computer having a wireless transceiver function, a mobile internet device (mobile internet device, MID), a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in telemedicine (remote medical), a wireless terminal in a smart grid (smart grid), a wireless terminal in transportation safety (transportation safety), a wireless terminal in a smart home (smart home), an uncrewed aerial vehicle, and an uncrewed aerial vehicle controller. Application scenarios are not limited in embodiments of this application. The terminal device sometimes may also be referred to as user equipment (user equipment, UE), a mobile station, a remote station, and the like. A specific technology, a device form, and a name that are used by the terminal device are not limited in embodiments of this application.

The network device in embodiments of this application includes a base station (base station, BS), a network controller, a mobile switching center, another access network device, or a core network device. The base station includes a macro base station, a micro base station, a relay station, an access point, or the like in various forms. For example, the base station may be a base station in the GSM or the CDMA, that is, a base transceiver station (base transceiver station, BTS), may be a base station in the WCDMA, that is, a NodeB, may be an evolved base station in the LTE, that is, an eNB or an e-NodeB, or may be a base station in the 5G system. The base station in the 5G system may be referred to as a transmission reception point (transmission reception point, TRP), or may be referred to as a next generation nodeB (generation NodeB, gNB). Further, the base station may be a base station in a future network. This is not limited in this application.

The technical solutions provided in embodiments of this application may be applied to the transmitting device, and further, may be applied to a transmitting apparatus of the transmitting device.

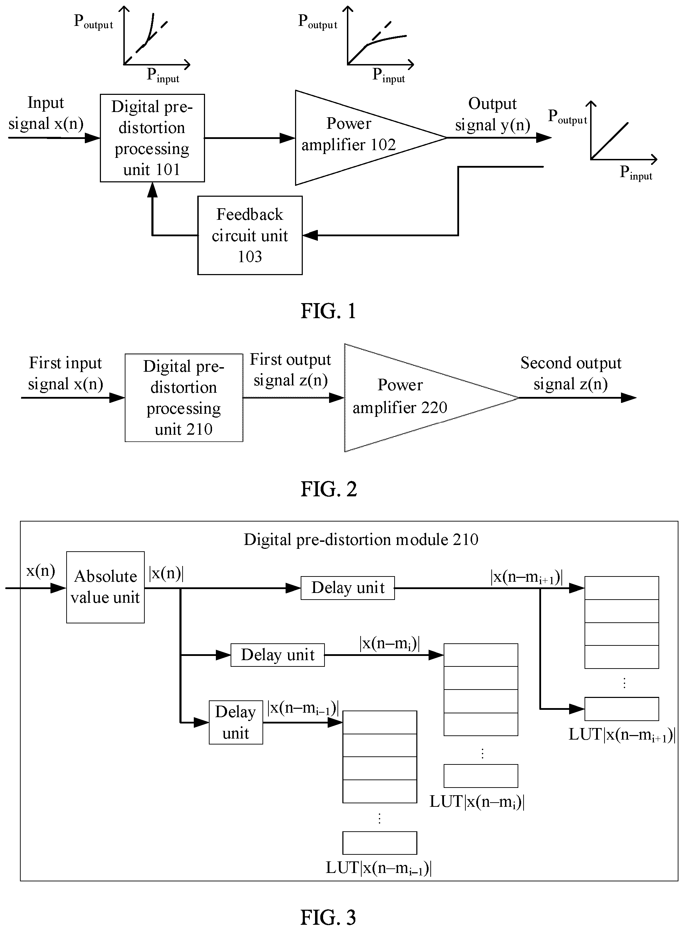

A PA is a non-linear component. To avoid distortion in a signal amplification process, linearization needs to be performed on the PA. Currently, a DPD solution may be used for the linearization of the PA. FIG. 1 is a schematic flowchart of a linearization solution for digital pre-distortion. As shown in FIG. 1, it is assumed that an input signal x(n) is directly input to a PA 102 without being processed by a DPD processing unit 101. When the input signal x(n) passes through the PA 102, due to a non-linear feature of the PA 102, signal distortion may be caused, and a non-linear distorted signal may be output. This may affect signal quality and communication efficiency. The DPD processing unit 101 is configured to perform preprocessing that is opposite to the feature of the PA 102 on the input signal x(n) before the input signal x(n) is input to the PA 102. In FIG. 2, in a coordinate graph above the DPD processing unit 101, a $P_{input}$ on a horizontal axis represents a signal input to the DPD processing unit 101, a $P_{output}$ on a vertical axis represents a signal output by the DPD processing unit 101, and a dashed line represents an undistorted input signal x(n) input to the DPD processing unit 101. Due to the non-linear feature of the PA, processing that is opposite to the non-linear feature of the PA 102 needs to be performed in the DPD processing unit 101. In this case, a solid line represents a feature of a signal actually output from the DPD processing unit 101. In a coordinate graph above the PA 102, a dashed line represents an undistorted input signal input to the PA 102. Due to the non-linear feature of the PA 102, a solid line represents a signal that is obtained, due to the non-linear feature of the PA 102, through output of the undistorted input signal input to the PA 102. It can be learned that, due to the non-linear feature of the PA 102, the signal output from the PA 102 may be distorted. Therefore, processing that is opposite to the non-linear feature of the PA 102 needs to be performed in the DPD processing unit 101. A feedback circuit unit 103 is disposed. To be specific, a part of the signal output from the PA passes through the feedback circuit unit 103 and then is transmitted to the DPD processing unit 101. The DPD processing unit 101 may obtain the non-linear feature of the PA 102 by processing the part of the signal, and therefore, processing that is opposite to the non-linear feature of the PA 102 may be performed in the DPD processing unit 101 in advance, and then a signal processed by the DPD processing unit 101 is input to the PA 102. Finally, the PA 102 may output a linear and undistorted signal. This ensures that the signal output from the PA 102 is linear and undistorted. In a coordinate graph on a right side of the PA 102, a solid line represents the signal output by the PA 102. It can be learned that, after pre-distortion is performed by the DPD processing unit 101, the signal output by the PA 102 is not distorted.

A non-linear distortion feature of the PA may be expressed by a polynomial. Therefore, the PA may be modeled by using the polynomial. Common PA models include a Volterra model, a memory polynomial (memory polynomial, MP) model, a generalized memory polynomial (Generalized Memory Polynomial, GMP) model, a Wiener model, a Hammerstein model, and the like. A mathematical expression of the memory polynomial model is shown in Formula (1):

$$z(n) = \sum_{k=1}^{K} \sum_{q=0}^{Q-1} ax(n-q) \mid x(n-q) \mid^{k-1} \tag{1}$$

x(n) indicates the input signal, z(n) indicates an output signal of the DPD processing unit, K indicates a polynomial order, Q indicates a memory depth, and a indicates a DPD coefficient.

To perform pre-distortion according to Formula (1), the DPD coefficient a needs to be calculated. There are a plurality of methods for calculating the DPD coefficient a. This is not limited in embodiments of this application.

Currently, when calculating the DPD coefficient, the feedback circuit unit needs to perform real-time iteration, which may increase additional power consumption. In addition, as a second feature (for example, a bandwidth, a temperature, or a frequency) changes, it is difficult for the feedback circuit unit to quickly obtain the DPD coefficient through calculation. Consequently, communication quality deteriorates. Based on this, embodiments of this application provide a digital pre-distortion circuit and an apparatus, to reduce power consumption and improve communication quality.

FIG. 2 is a diagram of a structure of a digital pre-distortion circuit according to an embodiment of this application. As shown in FIG. 2, the digital pre-distortion circuit 200 includes a DPD module 210 and a PA 220.

The DPD module 210 is configured to obtain a first feature of a first input signal and a second feature of the first input signal.

The DPD module 210 is configured to determine a first coefficient based on the first feature of the first input signal, and determine a second coefficient of the second feature based on the second feature.

The DPD module 210 is further configured to generate a second signal based on the first input signal and the first coefficient.

The DPD module 210 is further configured to generate a first output signal based on the second signal and the second coefficient.

The DPD module 210 is further configured to input the first output signal to the power amplifier.

The PA 220 is configured to amplify the first output signal.

In this embodiment of this application, a first output signal obtained through power amplification may be referred to as a second output signal.

According to the digital pre-distortion circuit provided in this embodiment of this application, the DPD module may determine the first coefficient and the second coefficient based on the first feature and the second feature of the first input signal, perform digital pre-distortion on the first input signal by using the first coefficient and the second coefficient, and then input a first output signal obtained through digital pre-distortion to the PA 220, to obtain the second output signal that is linear and undistorted.

The following describes in detail the digital pre-distortion circuit provided in this embodiment of this application.

After the first input signal is input to the DPD module 210, the DPD module 210 may obtain the first feature and the second feature of the first input signal, and then determine the first coefficient based on the first feature and determine the second coefficient based on the second feature.

A type of the first input signal is not limited in embodiments of this application. The first input signal may be a modulation signal, for example, an LTE signal or a 5G signal, or may be a continuous wave (continuous wave, CW) signal.

Optionally, the first feature of the first input signal may be a signal amplitude.

Optionally, the first feature of the first input signal may further include data carried in the first input signal and/or a signal amplitude of a second input signal and/or data carried in the second input signal. The data carried in the first input signal may be an in-phase component and a quadrature component of the first input signal, and the second input signal may be an input signal that has a specific time interval from the first input signal. For example, the first input signal is $x(n)$, and the second input signal may be $x(n-k)$. In this case, the feature of the first input signal may alternatively be the amplitude of the second input signal, that is, $|x(n-k)|$.

The DPD module 210 may determine the first coefficient in the following several manners.

In a possible implementation, the DPD module 210 stores a look-up table (look-up table, LUT). The look-up table may be understood as a mapping relationship. The mapping relationship indicates a correspondence between a plurality of first-type features and a plurality of coefficients. To be specific, the pre-calculated coefficients are stored in the table, and then, the DPD module 210 may calculate an address in the LUT based on the first feature of the first input signal, to determine the first coefficient. The first coefficient may be understood as a coefficient corresponding to the first feature in the mapping relationship. The first-type feature includes at least one of the amplitude, the in-phase component, and the quadrature component.

For example, the first feature is the amplitude of the first input signal. As shown in FIG. 3, the DPD module 210 may determine, through an absolute value unit, that an absolute value of the first input signal $x(n)$ input to the DPD module 210 is $|x(n)|$. The absolute value $|x(n)|$ of the first input signal indicates the signal amplitude of the first input signal. After determining the absolute value $|x(n)|$ of the first input signal, the DPD module 210 may obtain at least one index value through adjustment by a delay unit. As shown in FIG. 3, the DPD module 210 may obtain an index value $|x(n-m_1)|$ whose memory depth is $m_1$, an index value $|x(n-m_2)|$ whose memory depth is $m_2$, and an index value $|x(n-m_3)|$ whose memory depth is $m_3$, then determine LUTs corresponding to the index values based on the index values, that is, may determine 3 LUTs, and then search for corresponding coefficients in the corresponding LUTs based on the signal amplitude of the first input signal. In embodiments of this application, the coefficient determined by using the LUT is referred to as a DPD coefficient. In other words, DPD coefficients of different memory terms in a memory polynomial may be determined based on the signal amplitude of the first input signal.

It should be noted that the memory depth is related to the memory polynomial. In this embodiment of this application, an example in which the DPD module 210 obtains the index values of the three memory depths through the delay unit is used. However, embodiments of this application are not limited thereto.

In a possible implementation, the digital pre-distortion circuit 200 further includes a coefficient module 230. The coefficient module 230 stores a LUT. The look-up table may be understood as a mapping relationship. The mapping relationship indicates a correspondence between a plurality of first-type features and a plurality of coefficients. To be specific, the pre-calculated coefficients are stored in the table, and then, the DPD module 210 may calculate an address in the LUT based on the first feature of the first input signal, to determine the first coefficient.

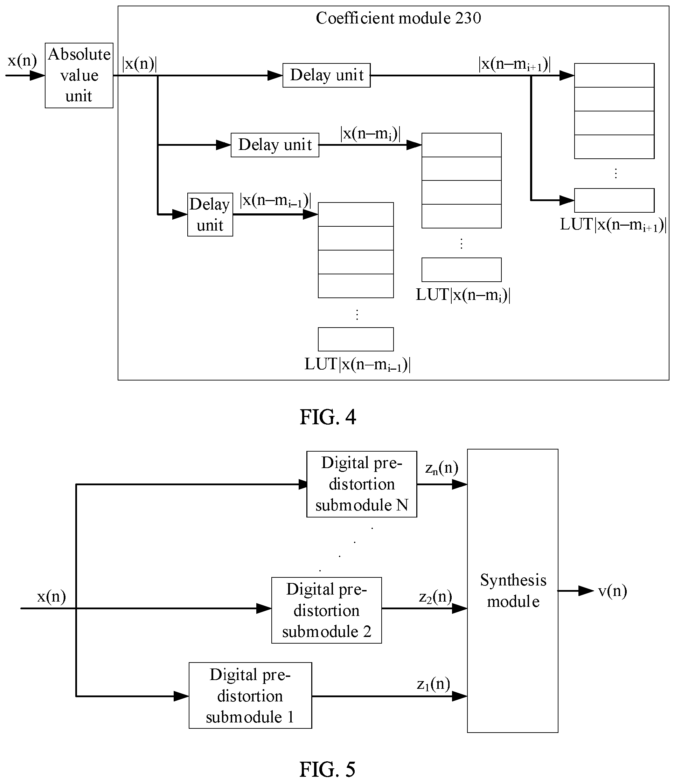

For example, as shown in FIG. 4, an absolute value $|x(n)|$ of the first input signal may be obtained after the first input signal passes through an absolute value unit. The absolute value of the first input signal is input to the coefficient module 230, and the coefficient module 230 may obtain an index value $|x(n-m_1)|$ whose memory depth is $m_1$, an index value $|x(n-m_2)|$ whose memory depth is $m_2$, and an index value $|x(n-m_3)|$ whose memory depth is $m_3$ through adjustment by the delay unit, then determine LUTs corresponding to the index values based on the index values, that is, may determine 3 LUTs, and then search for corresponding coefficients in the corresponding LUTs based on the signal amplitude of the first input signal. When the corresponding coefficients are searched for in the corresponding LUTs based on the signal amplitude of the first input signal, DPD coefficients of different memory terms may be determined. For specific descriptions, refer to the following descriptions.

Optionally, the second feature of the first input signal includes at least one of the following: a bandwidth of the first input signal, a temperature at which the digital pre-distortion circuit processes the first input signal, a frequency of the first input signal, a modulation format of the first input signal, and a standing wave generated when the digital pre-distortion circuit processes the first input signal.

In this embodiment of this application, the DPD module may determine the second coefficient in the following several manners.

In a possible implementation, the DPD module 210 stores an index table. The index table may be understood as a mapping relationship. The mapping relationship indicates a correspondence between a plurality of second-type features and a plurality of coefficients. The DPD module 210 may find the corresponding second coefficient in the index table based on the second feature of the first input signal. The second coefficient may be understood as a coefficient corresponding to the second feature in the mapping relationship. The second-type feature includes at least one of the bandwidth, the temperature, the frequency, the signal modulation format, and the standing wave.

In a possible implementation, the digital pre-distortion circuit 200 further includes the coefficient module 230, and the coefficient module 230 stores an index table. The DPD module 210 may determine the second coefficient in the coefficient module 230 based on the second feature of the first input signal.

It may be understood that, when the first input signal includes a plurality of second features, there are also a plurality of index tables stored in the DPD module 210 or the coefficient module 230.

For example, when the first input signal includes M second features, the DPD module may determine M second sub-coefficients based on the M second features of the first input signal. In other words, the second coefficient may include the M second sub-coefficients. For example, when the second feature is the bandwidth and the temperature, the DPD module 210 or the coefficient module 230 may store a first index table and a second index table. The first index table corresponds to the bandwidth, and the second index table corresponds to the temperature. Therefore, corresponding coefficients may be respectively determined in the first index table and the second index table based on the bandwidth and the temperature. In this embodiment of this application, a coefficient set determined based on different second features of the first input signal may be referred to as the second coefficient. In other words, the second coefficient may include a plurality of coefficients determined based on the different second features of the first input signal. In the foregoing example, the second coefficient includes the coefficient determined based on the bandwidth and the coefficient determined based on the temperature.

It is described above that the DPD module 210 determines the first coefficient and the second coefficient based on the first feature and the second feature of the first input signal. The following describes in detail that the DPD module 210 generates the second signal based on the first coefficient and the first input signal, and generates the first output signal based on the second signal and the second coefficient.

After the DPD module 210 determines the first coefficient based on the first feature of the first input signal, the first coefficient may include one DPD coefficient or a plurality of DPD coefficients of different memory terms, and the DPD module 210 may multiply the first input signal by the first coefficient, that is, multiply the first input signal by the DPD coefficient or the plurality of DPD coefficients of different memory terms, to obtain the second signal. After the second signal is generated, the second signal may be multiplied by the second coefficient to obtain the first output signal.

Optionally, in some embodiments, the DPD module 210 may include N DPD submodules and a synthesis module. N $\geq$ 1 and N is an integer.

FIG. 5 is a diagram of a structure of the DPD module 210. As shown in FIG. 5, the DPD module 210 includes the N DPD submodules and the synthesis module. The N DPD submodules may determine N first sub-coefficients based on a first feature of the first input signal x(n) and determine N second sub-coefficients based on a second feature of the first input signal. N $\geq$ 1 and N is an integer. Each of the N first sub-coefficients may include one DPD coefficient or a plurality of DPD coefficients. That the first sub-coefficient includes the plurality of DPD coefficients may be understood as that the first sub-coefficient includes the DPD coefficients of different memory terms. It may be understood that the N first sub-coefficients may form the first coefficient. In other words, the first coefficient may include the N first sub-coefficients. Similarly, the second coefficient includes the N second sub-coefficients. The N DPD submodules may generate N second sub-signals based on the N first sub-coefficients and the first input signal, and then generate N first output sub-signals based on the N second sub-signals and the N second sub-coefficients.

It should be noted that N is selected by considering factors such as final output performance and computing resources.

Optionally, in some embodiments, N = 1, and the second coefficient is a constant.

Optionally, in some embodiments, N = 2.

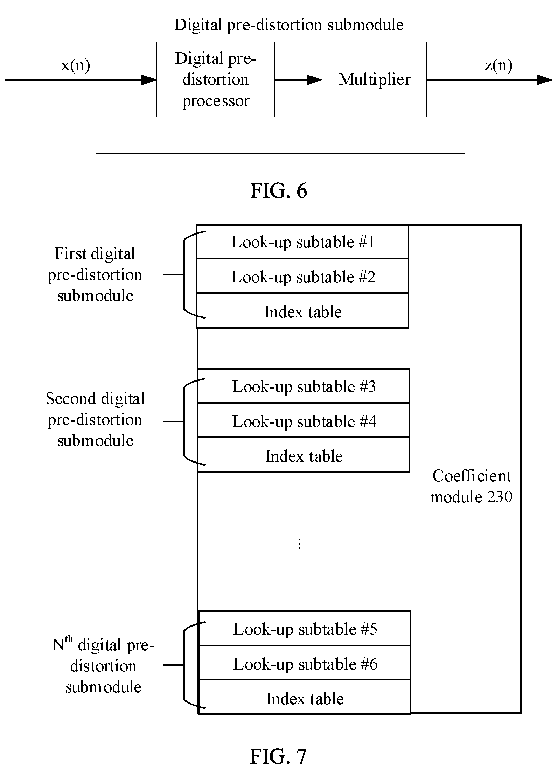

FIG. 6 is a diagram of a structure of the DPD submodule. As shown in FIG. 6, the DPD submodule may include a digital pre-distortion processor and a multiplier. The first input signal x(n) is input to the DPD submodule. The pre-distortion processor may determine the first sub-coefficient and the second coefficient based on the first input signal, and then the pre-distortion processor may multiply the first input signal by the first sub-coefficient, that is, multiply the first input signal by the DPD coefficient or the plurality of DPD coefficients of different memory terms, to generate a second sub-signal, and then multiply the second sub-signal by the second coefficient through the multiplier, to generate the first output sub-signal. It may be understood that the N first output sub-signals may be obtained through the N DPD submodules, and then the synthesis module may obtain the first output signal according to Formula (2).

$$v(n) = \sum_{k=1}^{N} z_k(n) \qquad\qquad (2)$$

It should be noted that an architecture of the digital pre-distortion processor is not limited in embodiments of this application. For example, the architecture of the digital pre-distortion processor may be an architecture based on the memory polynomial.

The DPD submodule may determine the first sub-coefficient and the second coefficient in the following several manners.

In a possible implementation, each DPD submodule stores an LUT and an index table that correspond to the DPD submodule. The LUT table corresponding to each DPD submodule may include LUTs of different memory terms. The DPD submodule may determine the first sub-coefficient and the second coefficient based on the first feature and the second feature of the first input signal.

It should be understood that, for descriptions that the DPD submodule stores the LUT and the index table that correspond to the DPD submodule, refer to the foregoing descriptions. For brevity, details are not described herein again.

In a possible implementation, the DPD submodule may determine, through the coefficient module 230, the first sub-coefficient and the second coefficient that correspond to the first input signal.

For example, the coefficient module 230 stores the LUT and the index table that correspond to each DPD submodule. The LUT corresponding to each DPD submodule may include sub-LUTs of different memory terms. For example, FIG. 7 is a diagram of a structure in which the coefficient module stores the LUT and the index table. As shown in FIG. 7, each of the N DPD submodules corresponds to one or more sub-LUTs and one or more environment index tables in the coefficient module 230. A quantity of the sub-LUT tables is related to the memory depth. For example, when a memory depth of an MP model is 3, there are three sub-LUTs. When two memory depths of a GMP model are 3 and 5 respectively, there are 15 sub-LUTs. Memory depths and memory terms in different DPD submodules may be the same or may be different. A quantity of the environment index tables is related to the second feature. For example, when the second feature includes M environment sub-features, each of the N DPD submodules includes M environment index tables. When the first input signal is input to the DPD submodule, each DPD submodule may determine the first sub-coefficient and the second sub-coefficient from the corresponding LUT and environment index table, to generate the first output sub-signal.

It should be noted that the first sub-coefficient and the second sub-coefficient that are determined by each of the N DPD submodules based on the first feature and the second feature of the first input signal may be the same or different.

After generating the first output signal, the DPD module 210 may input the first output signal to the PA 220, and the PA 220 may generate the second output signal based on the first output signal.

According to the digital pre-distortion circuit provided in this embodiment of this application, the DPD module 210 may determine the first coefficient and the second coefficient based on the first feature and the second feature of the first input signal, perform digital pre-distortion on the first input signal by using the first coefficient and the second coefficient, and then input a first output signal obtained through digital pre-distortion to the PA 220, to obtain the second output signal that is linear and undistorted.

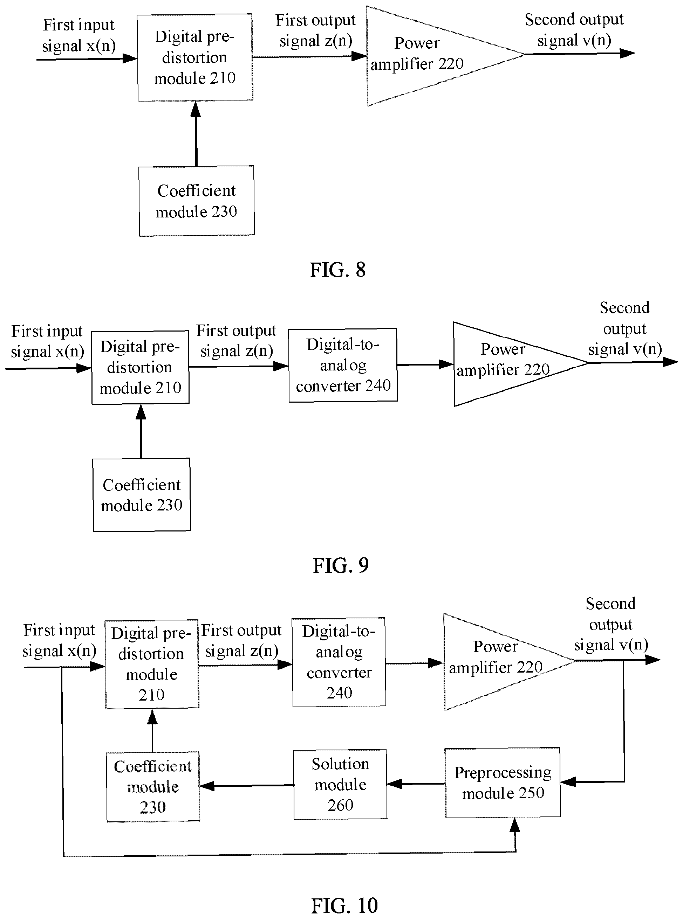

Optionally, in some embodiments, as shown in FIG. 8, the digital pre-distortion circuit 200 further includes the coefficient module 230. The coefficient module 230 stores the LUT and the index table.

It should be understood that, for descriptions of the coefficient module 230, refer to the foregoing descriptions. For brevity, details are not described herein again.

Optionally, in some embodiments, the PA may be a digital PA, or may be an analog PA. As shown in FIG. 9, the digital pre-distortion circuit 200 further includes a digital-to-analog converter (digital-to-analog converter, DAC) 240. The DAC 240 is configured to: convert the first output signal from the DPD module 210 to obtain an analog signal, and input the analog signal to the PA 220.

Further, in some embodiments, the digital pre-distortion circuit 200 further includes a passive component such as a filter or a frequency mixer between the DAC and the PA 220.

It should be noted that a type of the passive component is not limited in embodiments of this application.

The coefficient in the LUT and the coefficient in the index table that are stored in the DPD module 210 or the coefficient module 230 may be solved in advance.

For example, the second feature is the bandwidth. When the coefficient in the LUT and the coefficient in the index table are solved, DPD input signals and PA output signals in different bandwidths may be collected, to obtain a DPD coefficient and an index coefficient through solution according to a solution algorithm.

For example, when there are the plurality of second features, for example, the second feature includes the bandwidth and the temperature, when the coefficient in the LUT and the coefficient in the index table are solved, DPD input signals and PA output signals at different bandwidths and temperatures may be collected for solution, to obtain two index tables, which correspond to the two second features: the bandwidth and the temperature respectively.

It may be understood that, in this embodiment of this application, when the input signal and the output signal are solved, the second feature of the input signal is decoupled from the first feature of the input signal, so that the DPD coefficient corresponding to the first feature and the coefficient corresponding to the second feature can be obtained. Further, when a second feature is added or a value range of a specific second feature is changed, an index table corresponding to the second feature may be added or adjusted without changing the LUT of the DPD, so that a quantity of LUTs can be reduced, and storage pressure of a memory can be reduced.

It should be noted that, during solving, the first coefficient and the second coefficient may be determined based on a preset non-linear model according to the solution algorithm. For example, the non-linear model may be the memory polynomial model shown in Formula (1), or may be another model. This is not limited in this application. In addition, a solution method is not limited in this embodiment of this application. For example, a least square (least square, LS) algorithm and a variation thereof, or a least mean square (Least Mean Square, LMS) algorithm and a variation thereof may be used.

Optionally, in some embodiments, as shown in FIG. 10, the digital pre-distortion circuit 200 further includes a preprocessing module 250 and a solution module 260. The foregoing coefficient solution method may be preset in the solution module 260.

The first input signal and the second output signal are input to the preprocessing module 250, and an input signal of the preprocessing module 250 is input to the solution module 260.

An adjacent channel leakage ratio (adjacent channel leakage ratio, ACLR) of the first input signal to the second output signal exceeds a first threshold and/or an error vector magnitude (EVM) exceeds a second threshold.

In this case, the preprocessing module 250 is configured to preprocess the first input signal and the second output signal, to align the first input signal with the second output signal.

A preprocessing method used by the preprocessing module 250 is not limited in this embodiment of this application. For example, the preprocessing module 250 may use a preprocessing method such as gain alignment, delay alignment, or frequency/phase offset correction.

The preprocessing module 250 is further configured to input a preprocessed first input signal and second output signal to the solution module 260.

The solution module 260 is configured to process the preprocessed first input signal and second output signal according to an algorithm, to generate a third coefficient and a fourth coefficient.

Optionally, the solution module 260 is further configured to send the third coefficient and the fourth coefficient to the coefficient module 230.

The DPD module 210 is further configured to generate a third signal based on the first input signal and the third coefficient.

The DPD module 210 is further configured to generate a third output signal based on the third signal and the fourth coefficient.

The DPD module 210 is further configured to input the third output signal to the PA 220.

The PA 220 is further configured to amplify the third output signal.

In this embodiment of this application, an amplified third output signal may be referred to as a fourth output signal.

Optionally, in some embodiments, the first coefficient may be replaced with the third coefficient, and the second coefficient may be replaced with the fourth coefficient.

In this embodiment of this application, when the ACLR of the first input signal to the second output signal or the EVM exceeds the threshold, the digital pre-distortion circuit may re-solve for a new coefficient based on the first input signal and the second output signal, so that the digital pre-distortion circuit can generate the third output signal based on the third coefficient and the fourth coefficient, and then input the third output signal to the power amplifier, to further obtain the undistorted fourth output signal.

Further, in some embodiments, the digital pre-distortion circuit may further include a buffer. The buffer is configured to: store the first input signal and the second output signal, and then input the first input signal and the second output signal to the preprocessing module.

In this embodiment of this application, the digital pre-distortion circuit may further include the preprocessing module and the solution module. When the coefficient in the coefficient module cannot ensure performance of the DPD module, the coefficient in the coefficient module may be updated in real time to adapt to the input signal, to ensure that the PA output signal is not distorted.

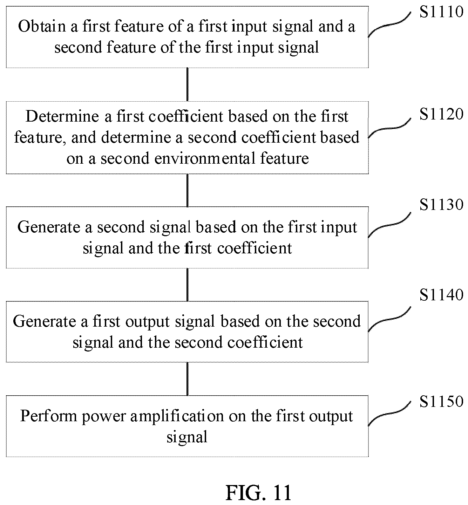

The foregoing describes the digital pre-distortion circuit provided in embodiments of this application. The following describes a digital pre-distortion method provided in embodiments of this application. FIG. 11 is a schematic flowchart of a digital pre-distortion method 1100 according to an embodiment of this application. The method is applied to a transmitting apparatus or a sending apparatus including the transmitting apparatus. The transmitting apparatus includes a DPD processing module, a PA, and a memory. The memory stores an LUT and index table of a DPD. As shown in FIG. 11, the method 1100 includes the following steps.

S1110: Obtain a first feature of a first input signal and a second feature of the first input signal.

Specifically, the transmitting apparatus may obtain the first input signal. The first input signal may be an LTE signal, a 5G signal, a continuous wave signal, or the like, to obtain the first feature of the first input signal and the second feature of the first input signal.

S1120: Determine a first coefficient based on the first feature of the first input signal, and determine a second coefficient based on the second feature.

Specifically, the transmitting apparatus may determine the first coefficient based on the first feature of the first input signal, and determine the second coefficient based on the second feature.

S1130: Generate a second signal based on the first input signal and the first coefficient.

Specifically, the transmitting apparatus may generate the second signal based on the first input signal and the first coefficient.

S1140: Generate a first output signal based on the second signal and the second coefficient.

Specifically, the transmitting apparatus may generate the first output signal based on the second signal and the second coefficient.

S1150: Perform power amplification on the first output signal, to generate a second output signal.

Specifically, the transmitting apparatus may process the first output signal by using the power amplifier, to generate the second output signal.

It should be understood that, for descriptions of S1110 to S1150, refer to the foregoing descriptions. For brevity, details are not described herein again.

In this embodiment of this application, the transmitting apparatus may determine the first coefficient and the second coefficient based on the first feature and the second feature of the first input signal, perform digital pre-distortion on the first input signal by using the first coefficient and the second coefficient, and then input a first output signal obtained through digital pre-distortion to the power amplifier, to obtain the second output signal that is linear and undistorted.

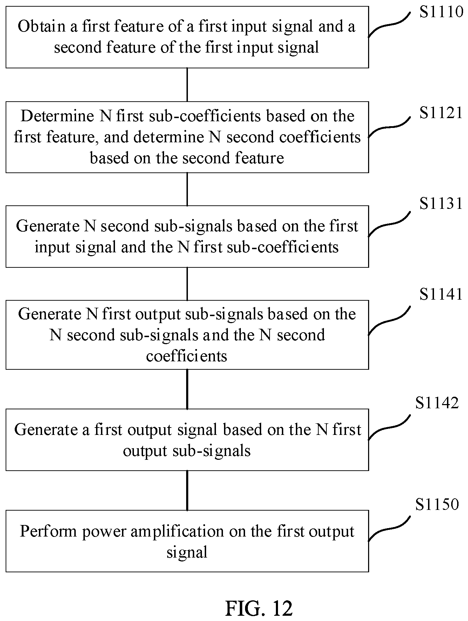

FIG. 12 is a schematic flowchart of an example of a digital pre-distortion method according to an embodiment of this application. As shown in FIG. 12, in S1120, determining the first coefficient based on the first feature of the first input signal and determining the second coefficient based on the second feature include the following step.

S1121: Determine N first sub-coefficients and N second sub-coefficients based on the first feature and the second feature of the first input signal.

Specifically, the transmitting apparatus may determine the N first sub-coefficients and the N second sub-coefficients based on the first feature and the second feature of the first input signal.

In S1130, generating the second signal based on the first input signal and the first coefficient includes the following step.

S1131: Generate N second sub-signals based on the first input signal and the N first sub-coefficients.

Specifically, the transmitting apparatus may generate the N second sub-signals based on the first input signal and the N first sub-coefficients.

In S1140, generating the first output signal based on the second signal and the second coefficient includes the following steps.

S1141: Generate N first output sub-signals based on the N second sub-signals and the N second sub-coefficients.

S1142: Generate the first output signal based on the N first output sub-signals.

Specifically, the transmitting apparatus may generate the N first output sub-signals based on the N second sub-signals and the N second coefficients, and then sum the N first output sub-signals to obtain the first output signal.

It should be understood that, for detailed descriptions of S1121, S1131, S1141, and S1142, refer to the foregoing descriptions. For brevity, details are not described herein again.

Optionally, in some embodiments, when the second feature of the first input signal includes M second features, the method 1100 further includes:
determining M second sub-coefficients based on the M second features of the first input signal.

In S1120, determining the second coefficient of the first input signal based on the second feature includes:
determining the second coefficient based on the M second sub-coefficients.

Specifically, after determining the M second sub-coefficients, the transmitting apparatus may determine the second coefficient based on the M sub-coefficients.

For example, the M second sub-coefficients may be multiplied to obtain the second coefficient.

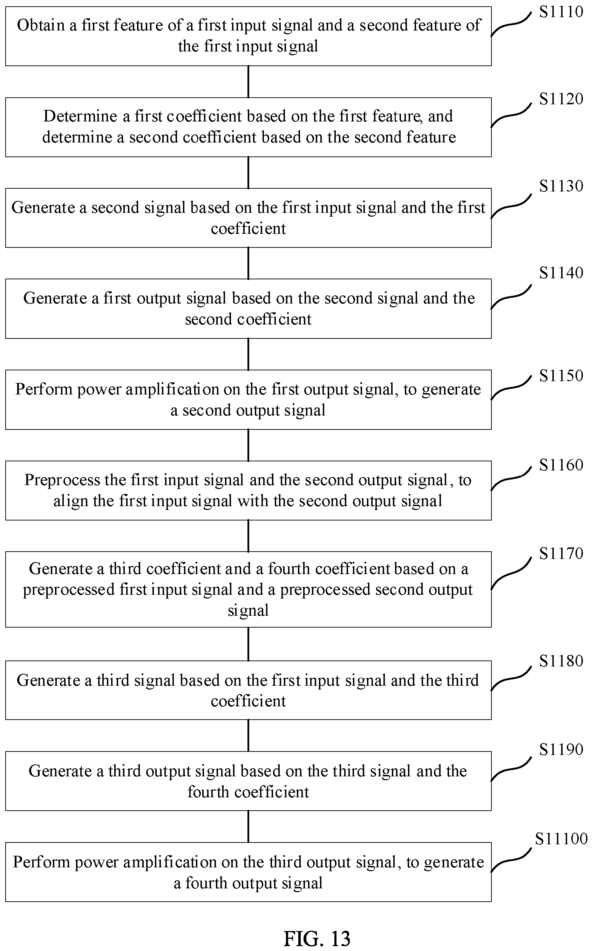

FIG. 13 is a schematic flowchart of an example of a digital pre-distortion method according to an embodiment of this application. As shown in FIG. 13, when an adjacent channel leakage ratio of the first input signal to the second output signal exceeds a first threshold and/or an error vector magnitude exceeds a second threshold, the method 1100 further includes the following steps.

S1160: Preprocess the first input signal and the second output signal, to align the first input signal with the second output signal.

S1170: Process a preprocessed first input signal and a preprocessed second output signal, to generate a third coefficient and a fourth coefficient.

S1180: Generate a third signal based on the first input signal and the third coefficient.

S1190: Generate a third output signal based on the third signal and the fourth coefficient.

S11100: Process the third output signal by using the power amplifier, to generate a fourth output signal. In this embodiment of this application, when the ACLR of the first input signal to the second output signal exceeds the first threshold and/or the EVM exceeds the second threshold, the digital pre-distortion circuit may re-solve for a new coefficient based on the first input signal and the second output signal, so that the digital pre-distortion circuit can generate the third output signal based on the third coefficient and the fourth coefficient, and then input the third output signal to the power amplifier, to further obtain the undistorted fourth output signal.

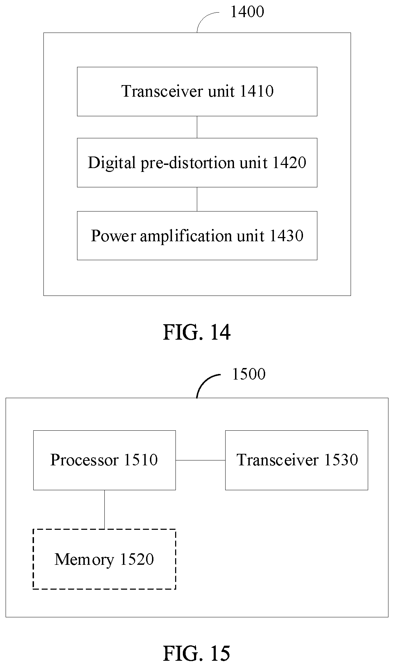

FIG. 14 shows a transmitting apparatus 1400 according to an embodiment of this application. The transmitting apparatus 1400 is used in a sending device. As shown in FIG. 14, the transmitting apparatus 1400 includes a transceiver unit 1410, a DPD unit 1420, and a power amplification unit 1430.

The transceiver unit 1410 is configured to receive a first input signal.

The DPD unit 1420 is configured to obtain a first feature of a first input signal and a second feature of the first input signal.

The DPD unit 1420 is configured to: determine a first coefficient based on the first feature, and determine a second coefficient based on the second feature.

The DPD unit 1420 is further configured to generate a second signal based on the first input signal and the first coefficient.

The DPD unit 1420 is further configured to generate a first output signal based on the second signal and the second coefficient.

The DPD unit 1420 is further configured to input the first output signal to the power amplification unit 1430.

The power amplification unit 1430 is configured to generate a second output signal based on the first output signal.

The transceiver unit 1410 is further configured to send the second output signal.

Optionally, in some embodiments, the transmitting apparatus further includes a coefficient unit. The coefficient unit stores an LUT and an index table.

The DPD unit 1420 is specifically configured to: extract the first coefficient from the coefficient unit based on the first feature, and extract the second coefficient from the coefficient unit based on the second feature.

Optionally, in some embodiments, the DPD unit 1420 is specifically configured to:

determine N first sub-coefficients based on the first feature of the first input signal, and determine N second sub-coefficients based on the second feature;

generate N second sub-signals based on the first input signal and N first coefficients;

generate N first output sub-signals based on the N second sub-signals and the N second sub-coefficients; and

generate the first output signal based on the N first output sub-signals.

Optionally, in some embodiments, the second feature includes M second sub-features, and the DPD unit 1420 is specifically configured to:

determine M second sub-coefficients based on the M second sub-features of the first input signal, where $M \geq 1$ and is an integer; and

determine the second coefficient based on the M second sub-coefficients.

Optionally, in some embodiments, the transmitting apparatus 1400 further includes a preprocessing unit and a solution unit. An algorithm used to solve for a coefficient may be preset in the solution unit. The first input signal and the second output signal are input to the preprocessing unit. When an adjacent channel leakage ratio of the first input signal to the second output signal exceeds a first threshold or an error vector magnitude exceeds a second threshold, the preprocessing unit is configured to preprocess the first input signal and the second output signal, to align the first input signal with the second output signal.

The preprocessing unit is further configured to input a preprocessed first input signal and a preprocessed second output signal to the solution unit.

The solution unit is configured to process the preprocessed first input signal and the preprocessed second output signal according to the algorithm, to generate a third coefficient and a fourth coefficient.

Optionally, the solution unit is further configured to input the third coefficient and the fourth coefficient to the coefficient unit.

The DPD unit 1420 is further configured to generate a third signal based on the first input signal and the third coefficient.

The DPD unit 1420 is further configured to generate a third output signal based on the third signal and the fourth coefficient.

The DPD unit 1420 is further configured to input the third output signal to the power amplification unit 1430.

The power amplification unit 1430 is further configured to generate a fourth output signal based on the third output signal.

The transceiver unit 1410 is further configured to send the fourth output signal.

As shown in FIG. 15, an embodiment of this application further provides a communication apparatus (for example, a transmitting device) 1500. The communication apparatus 1500 includes a processor 1510. The processor 1510 is coupled to a memory 1520. The memory 1520 is configured to store a computer program or instructions and/or data. The processor 1510 is configured to execute the computer program or the instructions and/or the data stored in the memory 1520, so that the method in the foregoing method embodiments is performed.

Optionally, the communication apparatus 1500 includes one or more processors 1510.

Optionally, the communication apparatus 1500 may include one or more memories 1520.

Optionally, the memory 1520 and the processor 1510 may be integrated together or disposed separately.

Optionally, as shown in FIG. 15, the wireless communication apparatus 1500 may further include a transceiver 1530. The transceiver 1530 is configured to: receive and/or send a signal. For example, the processor 1510 is configured to control the transceiver 1530 to receive and/or send the signal.

In a solution, the communication apparatus 1500 is configured to implement operations performed by the units in the transmitting apparatus in the foregoing method embodiments.

An embodiment of this application further provides a computer-readable storage medium. The computer-readable storage medium stores computer instructions used to implement the method performed by the transmitting apparatus or the method performed by the transmitting apparatus in the foregoing method embodiments.

An embodiment of this application further provides a computer program product. When a computer program is executed by a computer, the computer is enabled to implement the method performed by the transmitting device in the foregoing method embodiments.

An embodiment of this application further provides a communication system. The communication system includes the communication device in the foregoing embodiments.

For explanations and beneficial effects of related content of any wireless communication apparatus provided above, refer to the corresponding method embodiment provided above. Details are not described herein again.

In this embodiment of this application, the communication device may include a hardware layer, an operating system layer running above the hardware layer, and an application layer running above the operating system layer. The hardware layer may include hardware such as a central processing unit (central processing unit, CPU), a memory management unit (memory management unit, MMU), and memory (also referred to as main memory). An operating system at the operating system layer may be any one or more computer operating systems that implement service processing through a process (process), for example, a Linux operating system, a Unix operating system, an Android operating system, an iOS operating system, or a Windows operating system. The application layer may include applications such as a browser, an address book, word processing software, and instant messaging software.

A specific structure of an execution body of the method provided in embodiments of this application is not specifically limited in embodiments of this application, provided that a program that records code of the method provided in embodiments of this application can be run to perform communication according to the method provided in embodiments of this application. For example, the execution body of the method provided in embodiments of this application may be a terminal device or a satellite, or may be a functional module that is in the terminal device or the satellite and that can invoke a program and execute the program.

Aspects or features in embodiments of this application may be implemented as a method, an apparatus, or a product that uses standard programming and/or engineering technologies. The term "product" used in this specification may cover a computer program that can be accessed from any computer-readable component, carrier or medium. For example, a computer-readable medium may include but is not limited to a magnetic storage component (for example, a hard disk, a floppy disk, or a magnetic tape), an optical disc (for example, a compact disc (compact disc, CD) or a digital versatile disc (digital versatile disc, DVD)), a smart card, and a flash memory component (for example, an erasable programmable read-only memory (erasable programmable read-only memory, EPROM), a card, a stick, or a key drive).

Various storage media described in this specification may indicate one or more devices and/or other machine-readable media that are configured to store information. The term "machine-readable media" may include but is not limited to a radio channel and various other media that can store, include, and/or carry instructions and/or data.

It should be understood that the processor in embodiments of this application may be a central processing unit (central processing unit, CPU), another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or the like. The general-purpose processor may be a microprocessor, or the processor may be any conventional processor or the like.

It should be further understood that the memory mentioned in embodiments of this application may be a volatile memory or a non-volatile memory, or may include a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM). For example, the RAM may be used as an external cache. By way of example and not limitation, the RAM may include the following plurality of forms: a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

It should be noted that, when the processor is a general-purpose processor, a DSP, an ASIC, an FPGA or another programmable logic device, a discrete gate or a transistor logic device, or a discrete hardware component, the memory (storage module) may be integrated into the processor.

It should further be noted that the memory described herein is intended to include but is not limited to these and any other appropriate type of memory.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of embodiments of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in embodiments of this application, it should be understood that the disclosed system, apparatus, and method may be implemented in other manners. For example, the described apparatus embodiment is merely an example. For example, the described apparatus embodiments are merely examples. For example, division into the units is merely logical function division and may be other division in actual implementation. For example, a plurality of units or components may be combined or integrated into another system, or some features may be ignored or may not be performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual requirements to achieve the objectives of the solutions of embodiments.

In addition, functional units in embodiments of this application may be integrated into one processing unit, each of the units may exist alone physically, or two or more units may be integrated into one unit.

When the functions are implemented in a form of software functional unit and sold or used as an independent product, the functions may be stored in a computer-readable storage medium. Based on such an understanding, the technical solutions of embodiments of this application essentially, or the part contributing to the conventional technology, or some of the technical solutions may be implemented in a form of software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in embodiments of this application shall fall within the protection scope of this application. Therefore, the protection scope of this application shall be subject to the protection scope of the claims.

**Claims**

1. A digital pre-distortion circuit, wherein the digital pre-distortion circuit comprises a digital pre-distortion module and a power amplifier, wherein

the digital pre-distortion module is configured to obtain a first feature of a first input signal and a second feature of the first input signal, wherein the first feature of the first input signal comprises at least one of the following: an amplitude of the first input signal, an in-phase component of the first input signal, and a quadrature component of the first input signal, and the second feature comprises at least one of the following: a bandwidth of the first input signal, a temperature at which the digital pre-distortion circuit processes the first input signal, a frequency of the first input signal, a modulation format of the first input signal, and a standing wave generated when the digital pre-distortion circuit processes the first input signal; and the digital pre-distortion module is configured to: determine a first coefficient based on the first feature, and determine a second coefficient based on the second feature, and is configured to: generate a second signal based on the first input signal and the first coefficient, generate a first output signal based on the second signal and the second coefficient, and input the first output signal to the power amplifier; and

the power amplifier is configured to amplify the first output signal, to generate a second output signal.

2. The digital pre-distortion circuit according to claim 1, wherein the digital pre-distortion circuit further comprises a coefficient module, the coefficient module stores a correspondence between the first feature and the first coefficient and a correspondence between the second feature and the second coefficient, and the digital pre-distortion module is specifically configured to: extract the first coefficient from the coefficient module based on the first feature, and extract the second coefficient from the coefficient module based on the second feature.

3. The digital pre-distortion circuit according to claim 1 or 2, wherein the digital pre-distortion module comprises N digital pre-distortion submodules and a synthesis module, and the N digital pre-distortion submodules are configured to: determine N first sub-coefficients based on the first feature, and determine N second sub-coefficients based on the second feature, wherein $N \geq 1$ and N is an integer, and the N first sub-coefficients are different;

generate N second sub-signals based on the first input signal and the N first sub-coefficients; and
generate N first output sub-signals based on the N second sub-signals and the N second sub-coefficients; and
the synthesis module is configured to generate the first output signal based on the N first output sub-signals.

4. The digital pre-distortion circuit according to any one of claims 1 to 3, wherein the digital pre-distortion circuit further comprises a preprocessing module and a solution module, an algorithm used to solve for a coefficient is preset in the solution module, the first input signal and the second output signal are input to the preprocessing module, and when an adjacent channel leakage ratio of the first input signal to the second output signal exceeds a first threshold and/or an error vector magnitude exceeds a second threshold, the preprocessing module is configured to: preprocess the first input signal and the second output signal, to align the first input signal with the second output signal; and

input a preprocessed first input signal and a preprocessed second output signal to the solution module;
the solution module is configured to process the preprocessed first input signal and the preprocessed second output signal according to the algorithm, to generate a third coefficient and a fourth coefficient;
the digital pre-distortion module is further configured to: generate a third signal based on the first input signal and the third coefficient;
generate a third output signal based on the third signal and the fourth coefficient; and
input the third output signal to the power amplifier; and
the power amplifier is configured to amplify the third output signal.

5. The digital pre-distortion circuit according to any one of claims 1 to 4, wherein the digital pre-distortion circuit further comprises a digital-to-analog converter, wherein
the digital-to-analog converter is configured to: obtain the first output signal from the digital pre-distortion circuit, perform digital-to-analog conversion on the first output signal, and input the first output signal obtained through the digital-to-analog conversion to the power amplifier.

6. A digital pre-distortion method, wherein the method comprises:

obtaining a first feature of a first input signal and a second feature of the first input signal, wherein the first feature of the first input signal comprises at least one of the following: an amplitude of the first input signal, an in-phase component of the first input signal, and a quadrature component of the first input signal, and the second feature comprises at least one of the following: a bandwidth of the first input signal, a temperature at which the digital pre-distortion circuit processes the first input signal, a frequency of the first input signal, a modulation format of the first input signal, and a standing wave generated when the digital pre-distortion circuit processes the first input signal;

determining a first coefficient based on the first feature, and determining a second coefficient based on the second feature;

generating a second signal based on the first input signal and the first coefficient;

generating a first output signal based on the second signal and the second coefficient; and

performing power amplification on the first output signal, to generate a second output signal.

7. The method according to claim 6, wherein the determining a first coefficient based on the first feature of the first input signal, and determining a second coefficient based on the second feature comprises:

determining N first sub-coefficients based on the first feature, and determining N second sub-coefficients based on the second feature, wherein the N first sub-coefficients are different;

the generating a second signal based on the first input signal and the first coefficient comprises:

generating N second sub-signals based on the first input signal and the N first sub-coefficients; and

the generating a first output signal based on the second signal and the second coefficient comprises:

generating N first output sub-signals based on the N second sub-signals and the N second sub-coefficients; and

generating the first output signal based on the N first output sub-signals.

8. The method according to claim 6 or 7, wherein when an adjacent channel leakage ratio of the first input signal to the second output signal exceeds a first threshold and/or an error vector magnitude exceeds a second threshold, the method further comprises:

preprocessing the first input signal and the second output signal, to align the first input signal with the second output signal;

processing the preprocessed first input signal and the preprocessed second output signal, to generate a third coefficient and a fourth coefficient;

generating a third signal based on the first input signal and the third coefficient;

generating a third output signal based on the third signal and the fourth coefficient; and

performing power amplification on the third output signal, to generate a fourth output signal.

9. A transmitting apparatus, wherein the transmitting apparatus comprises a transceiver unit, a digital pre-distortion unit, and a power amplification unit, wherein

the transceiver unit is configured to receive a first input signal;

the digital pre-distortion unit is configured to: obtain a first feature of the first input signal and a second feature of the first input signal, wherein the first feature of the first input signal comprises at least one of the following: an amplitude of the first input signal, an in-phase component of the first input signal, and a quadrature component of the first input signal, and the second feature comprises at least one of the following: a bandwidth of the first input signal, a temperature at which the digital pre-distortion circuit processes the first input signal, a frequency of the first input signal, a modulation format of the first input signal, and a standing wave generated when the digital pre-distortion circuit processes the first input signal;

determine a first coefficient based on the first feature, and determine a second coefficient based on the second feature;

generate a second signal based on the first input signal and the first coefficient;

generate a first output signal based on the second signal and the second coefficient; and input the first output signal to the power amplification unit;

the power amplification unit is configured to amplify the first output signal, to generate a second output signal; and

the transceiver unit is further configured for the second output signal.

10. The transmitting apparatus according to claim 9, wherein the transmitting apparatus further comprises a coefficient unit, and the coefficient unit stores a correspondence between the first feature and the first coefficient and a correspondence between the second feature and the second coefficient; and

the digital pre-distortion unit is specifically configured to: extract the first coefficient from the coefficient unit based on the first feature, and extract the second coefficient from the coefficient unit based on the second feature.

11. The transmitting apparatus according to claim 9 or 10, wherein the digital preprocessing unit is specifically configured to:

determine N first sub-coefficients based on the first feature, and determine N second sub-coefficients based on the second feature, wherein the N first sub-coefficients are different;
generate N second sub-signals based on the first input signal and the N first coefficients;
generate N first output sub-signals based on the N second sub-signals and the N second sub-coefficients; and
generate the first output signal based on the N first output sub-signals.

12. The transmitting apparatus according to any one of claims 9 to 11, wherein the transmitting apparatus further comprises a preprocessing unit and a solution unit, an algorithm used to solve for a coefficient is preset in the solution unit, the first input signal and the second output signal are input to the preprocessing unit, and when an adjacent channel leakage ratio of the first input signal to the second output signal exceeds a first threshold or an error vector magnitude exceeds a second threshold, the preprocessing unit is configured to preprocess the first input signal and the second output signal, to align the first input signal with the second output signal;

the preprocessing unit is further configured to input a preprocessed first input signal and a preprocessed second output signal to the solution unit;
the solution unit is configured to process the preprocessed first input signal and the preprocessed second output signal according to the algorithm, to generate a third coefficient and a fourth coefficient;
the digital pre-distortion unit is further configured to: generate a third signal based on the first input signal and the third coefficient;
generate a third output signal based on the third signal and the fourth coefficient; and
input the third output signal to the power amplification unit;
the power amplification unit is further configured to amplify the third output signal; and
the transceiver unit is further configured to send an amplified third output signal.

13. A transmitting device, wherein the transmitting device comprises the digital pre-distortion circuit according to any one of claims 1 to 5, or the transmitting device comprises the transmitting apparatus according to any one of claims 9 to 12.

14. A transmitting device, comprising one or more processors, one or more memories, and one or more transceivers, wherein the one or more memories store one or more computer programs, the one or more computer programs comprise instructions, and when the instructions are executed by the one or more processors, the method according to any one of claims 6 to 8 is performed.

15. A computer-readable storage medium, wherein the computer-readable storage medium stores a computer program or instructions, and the computer program or instructions are used to implement the method according to any one of claims 6 to 8.

16. A computer program product, wherein the computer program product comprises a computer program, and when the computer program is run, a computer is enabled to perform the method according to any one of claims 6 to 8.

17. A chip, wherein the chip comprises a processor and a communication interface, the communication interface is configured to: receive a signal, and transmit the signal to the processor, and the processor processes the signal, so that the method according to any one of claims 6 to 8 is performed.

FIG. 1

FIG. 2

FIG. 3

Coefficient module 230

x(n) → Absolute value unit → |x(n)|

Delay unit → |x(n−m$_{i+1}$)| → [LUT]

⋮

LUT|x(n−m$_{i+1}$)|

Delay unit → |x(n−m$_i$)| → [LUT]

⋮

LUT|x(n−m$_i$)|

Delay unit → |x(n−m$_{i−1}$)| → [LUT]

⋮

LUT|x(n−m$_{i−1}$)|

**FIG. 4**

x(n) → Digital pre-distortion submodule N → z$_n$(n) → Synthesis module

.
.
.

x(n) → Digital pre-distortion submodule 2 → z$_2$(n) → Synthesis module

x(n) → Digital pre-distortion submodule 1 → z$_1$(n) → Synthesis module → v(n)

**FIG. 5**

x(n)

Digital pre-distortion submodule

Digital pre-distortion processor

Multiplier

z(n)

**FIG. 6**

First digital pre-distortion submodule

Look-up subtable #1

Look-up subtable #2

Index table

Second digital pre-distortion submodule

Look-up subtable #3

Look-up subtable #4

Index table

Coefficient module 230

⋮

$N^{th}$ digital pre-distortion submodule

Look-up subtable #5

Look-up subtable #6

Index table

**FIG. 7**

First input
signal x(n)

Digital pre-
distortion
module 210

First output
signal z(n)

Power
amplifier 220

Second output
signal v(n)

Coefficient
module 230

FIG. 8

First input
signal x(n)

Digital pre-
distortion
module 210

First output
signal z(n)

Digital-to-
analog
converter 240

Power
amplifier 220

Second
output
signal v(n)

Coefficient
module 230

FIG. 9

First input
signal x(n)

Digital pre-
distortion
module
210

First output
signal z(n)

Digital-to-
analog
converter
240

Power
amplifier 220

Second
output
signal v(n)

Coefficient
module
230

Solution
module
260

Preprocessing
module 250

FIG. 10

Obtain a first feature of a first input signal and a
second feature of the first input signal — S1110

Determine a first coefficient based on the first
feature, and determine a second coefficient based
on a second environmental feature — S1120

Generate a second signal based on the first input
signal and the first coefficient — S1130

Generate a first output signal based on the second
signal and the second coefficient — S1140

Perform power amplification on the first output
signal — S1150

FIG. 11

Obtain a first feature of a first input signal and a second feature of the first input signal — S1110

Determine N first sub-coefficients based on the first feature, and determine N second coefficients based on the second feature — S1121

Generate N second sub-signals based on the first input signal and the N first sub-coefficients — S1131

Generate N first output sub-signals based on the N second sub-signals and the N second coefficients — S1141

Generate a first output signal based on the N first output sub-signals — S1142

Perform power amplification on the first output signal — S1150

FIG. 12

Obtain a first feature of a first input signal and a second feature of the first input signal — S1110

Determine a first coefficient based on the first feature, and determine a second coefficient based on the second feature — S1120

Generate a second signal based on the first input signal and the first coefficient — S1130

Generate a first output signal based on the second signal and the second coefficient — S1140

Perform power amplification on the first output signal, to generate a second output signal — S1150

Preprocess the first input signal and the second output signal, to align the first input signal with the second output signal — S1160

Generate a third coefficient and a fourth coefficient based on a preprocessed first input signal and a preprocessed second output signal — S1170

Generate a third signal based on the first input signal and the third coefficient — S1180

Generate a third output signal based on the third signal and the fourth coefficient — S1190

Perform power amplification on the third output signal, to generate a fourth output signal — S11100

FIG. 13

1400

Transceiver unit 1410

Digital pre-distortion unit 1420

Power amplification unit 1430

FIG. 14

1500

Processor 1510

Transceiver 1530

Memory 1520

FIG. 15

**INTERNATIONAL SEARCH REPORT**

International application No.

**PCT/CN2023/070659**

**A.    CLASSIFICATION OF SUBJECT MATTER**

H03F1/32(2006.01)i

According to International Patent Classification (IPC) or to both national classification and IPC

**B.    FIELDS SEARCHED**

Minimum documentation searched (classification system followed by classification symbols)

IPC：H03F, H04K, H04B, H04L

Documentation searched other than minimum documentation to the extent that such documents are included in the fields searched

Electronic data base consulted during the international search (name of data base and, where practicable, search terms used)

CNTXT, ENTXT, VEN, IEEE: 数字预失真, 第二, 输入, 系数, 查找表, 放大, digital pre 1w distor+, second, input, coefficient, look 1w up table, amplif+

**C.    DOCUMENTS CONSIDERED TO BE RELEVANT**

| Category* | Citation of document, with indication, where appropriate, of the relevant passages | Relevant to claim No. |
|---|---|---|
| X | CN 1474516 A (LG ELECTRONICS INC.) 11 February 2004 (2004-02-11) description, pp. 5, 11, and 16-19, and figures 6 and 11 | 1-17 |
| A | CN 107659273 A (SOUTHEAST UNIVERSITY) 02 February 2018 (2018-02-02) entire document | 1-17 |
| A | CN 103296978 A (COMBA TELECOM SYSTEMS (CHINA) CO., LTD.) 11 September 2013 (2013-09-11) entire document | 1-17 |
| A | CN 103888395 A (COMBA TELECOM SYSTEM (GUANGZHOU) CO., LTD.) 25 June 2014 (2014-06-25) entire document | 1-17 |
| A | US 7545880 B1 (RF MICRO DEVICES, INC.) 09 June 2009 (2009-06-09) entire document | 1-17 |
| A | KR 101679230 B1 (SOGANG UNIVERSITY RESEARCH FOUNDATION) 24 November 2016 (2016-11-24) entire document | 1-17 |

☐ Further documents are listed in the continuation of Box C.    ☑ See patent family annex.

\* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search

**19 March 2023**

Date of mailing of the international search report

**23 March 2023**

Name and mailing address of the ISA/CN

**China National Intellectual Property Administration (ISA/CN)**
**China No. 6, Xitucheng Road, Jimenqiao, Haidian District, Beijing 100088**

Facsimile No. **(86-10)62019451**

Authorized officer

Telephone No.

Form PCT/ISA/210 (second sheet) (July 2022)

**INTERNATIONAL SEARCH REPORT**
**Information on patent family members**

International application No.

**PCT/CN2023/070659**

| Patent document cited in search report | | | Publication date (day/month/year) | Patent family member(s) | | | Publication date (day/month/year) |
|---|---|---|---|---|---|---|---|
| CN | 1474516 | A | 11 February 2004 | US | 2004017257 | A1 | 29 January 2004 |
| | | | | US | 7034612 | B2 | 25 April 2006 |
| | | | | KR | 20040009013 | A | 31 January 2004 |
| | | | | KR | 20040054420 | A | 25 June 2004 |
| | | | | KR | 486547 | B1 | 03 May 2005 |
| | | | | KR | 808336 | B1 | 27 February 2008 |
| | | | | CN | 1270492 | C | 16 August 2006 |
| CN | 107659273 | A | 02 February 2018 | | None | | |
| CN | 103296978 | A | 11 September 2013 | | None | | |
| CN | 103888395 | A | 25 June 2014 | | None | | |
| US | 7545880 | B1 | 09 June 2009 | US | 7551686 | B1 | 23 June 2009 |
| KR | 101679230 | B1 | 24 November 2016 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- RU 2022114387